Europäisches Patentamt

European Patent Office

Office européen des brevets

(11) Publication number: **0 112 948**
**B1**

# EUROPEAN PATENT SPECIFICATION

(45) Date of publication of patent specification: **20.07.88**    (51) Int. Cl.⁴: **G 01 R 19/175**

(21) Application number: **82307005.7**

(22) Date of filing: **30.12.82**

(54) **Power frequency detection system.**

(43) Date of publication of application:
**11.07.84 Bulletin 84/28**

(45) Publication of the grant of the patent:
**20.07.88 Bulletin 88/29**

(84) Designated Contracting States:
**DE FR GB IT**

(56) References cited:
**DE-B-2 713 945**

**IBM TECHNICAL DISCLOSURE BULLETIN, vol. 24, no. 10, March 1982, pp. 5025-5027, New York (US); J.H.DODGE et al.: "Microcomputer control of zero-crossing detection accuracy"**

**PATENTS ABSTRACTS OF JAPAN, vol. 6, no. 141(P-131)(1019), 30th July 1982, Tokyo (JP) & JP-A-57-64170**

(73) Proprietor: **SHARP KABUSHIKI KAISHA**
**22-22 Nagaike-cho Abeno-ku**
**Osaka 545 (JP)**

(72) Inventor: **Ise, Masahiro**
**2187 Mise-cho**
**Kashihara-shi Nara-ken (JP)**
Inventor: **Tanaka, Hidehiko**
**2613-1 Ichinomoto-cho**
**Tenri-shi Nara-ken (JP)**
Inventor: **Machino, Katsuyuki**
**1-31-101 Higashikidera-cho**
**Nara-shi Nara-ken (JP)**
Inventor: **Matsubara, Toshiyuki**
**2613-1 Ichinomoto-cho**
**Tenri-shi Nara-ken (JP)**
Inventor: **Terasaka, Teiji**
**2613-1 Ichinomoto-cho**
**Tenri-shi Nara-ken (JP)**

(74) Representative: **Wright, Peter David John et al**
**R.G.C. Jenkins & Co. 26 Caxton Street**
**London SW1H 0RJ (GB)**

Courier Press, Leamington Spa, England.

## Description

The present invention relates to a detection system for detecting a frequency of a power supply voltage and, preferably, to a power frequency detection circuit in a signal transmission system which utilizes the building or house wiring.

A signal transmission system has been developed, which utilizes the building or house wiring as a data transmission line. In such a signal transmission system, the power frequency is often used as a reference clock. To achieve accurate operation, the power frequency must be correctly detected without interference from noise.

The present invention therefore relates to a system of the type which is operable to provide detection signals when the level of the power voltage reaches a predetermined value, and is arranged such that the provision of said detection signals is inhibited for a predetermined period after the provision of each detection signal.

IBM Technical Disclosure Bulletin Vol. 24 No. 10, March 1982 discloses at pages 5025 to 5027 an arrangement in which a microprocessor performs a predetermined count based on the microcomputer internal clock following each accepted zero-crossing. No further zero-crossings are accepted until the count is finished, so as to create an inspection window in the vicinity of the anticipated next zero-crossing time. Thus noise signals occurring during the count are ignored. The count takes a predetermined period slightly less than the period of the timing signal to be obtained from the power voltage.

The present invention provides an alternative arrangement for ignoring noise for predetermined periods.

According to the present invention there is provided a power line signal transmission system incorporating a detection system for detecting the frequency of a power voltage of said power line, the detection system being operable to provide detection signals when the instantaneous level of the power voltage reaches a predetermined value, and being arranged such that the provision of said detection signals is inhibited for a predetermined period after the provision of each detection signal by a non-retriggerable monostable multivibrator, the said predetermined period being less than the period of said power voltage and the multivibrator being arranged to be triggered to generate a said detection signal in response to the power voltage reaching said predetermined value, each said detection signal comprising a pulse having a width substantially equal to the said predetermined period.

Usually the said predetermined value is substantially the centre value of the oscillations of the power voltage. Preferably the said pulse width is less than half the period of the power voltage and the system is operable to provide detection signals when the power voltage passes the predetermined value in either direction.

Preferably the system comprises detection circuit means which provides a trigger input pulse to the monostable multivibrator when the power voltage passes the predetermined value, the detection circuit means providing a said trigger input pulse of the same polarity for movement of the power voltage past the predetermined value in either direction.

In one embodiment of the present invention the detection circuit means comprises level detection means which outputs a signal to first and second inputs of an Exclusive-OR gate which signal varies between a logic "1" and a logic "0" as the power voltage passes the predetermined value, the detection circuit means also comprising means to delay the signal at the second input of the Exclusive-OR gate relative to the first so that following a movement of the power voltage past the predetermined value the logic value at the said first and second inputs do not change simultaneously, the output of the Exclusive-OR gate being used to provide the said trigger input pulse.

In another embodiment of the present invention the detection circuit means comprises two photocouplers arranged so that one provides an output when the power voltage is substantially above the predetermined value and the other provides an output when the power voltage is substantially below the predetermined value, the outputs of the photocouplers being combined in an OR function so as to provide a combined output of a first value when the power voltage is substantially different from the predetermined value and a second value when the power voltage is substantially at the predetermined value, the combined output being used to provide the said trigger input pulse.

An embodiment of the present invention, given by way of example, will now be described with reference to the accompanying drawings, in which:

FIGURE 1 is a schematic circuit diagram of a prior art power frequency detection circuit;

FIGURE 2 is a waveform chart for explaining an operational mode of the power frequency detection circuit of FIGURE 1;

FIGURE 3 is a circuit diagram of a power frequency detection system embodying the present invention;

FIGURE 4 is a circuit diagram of another power frequency detection system embodying the present invention;

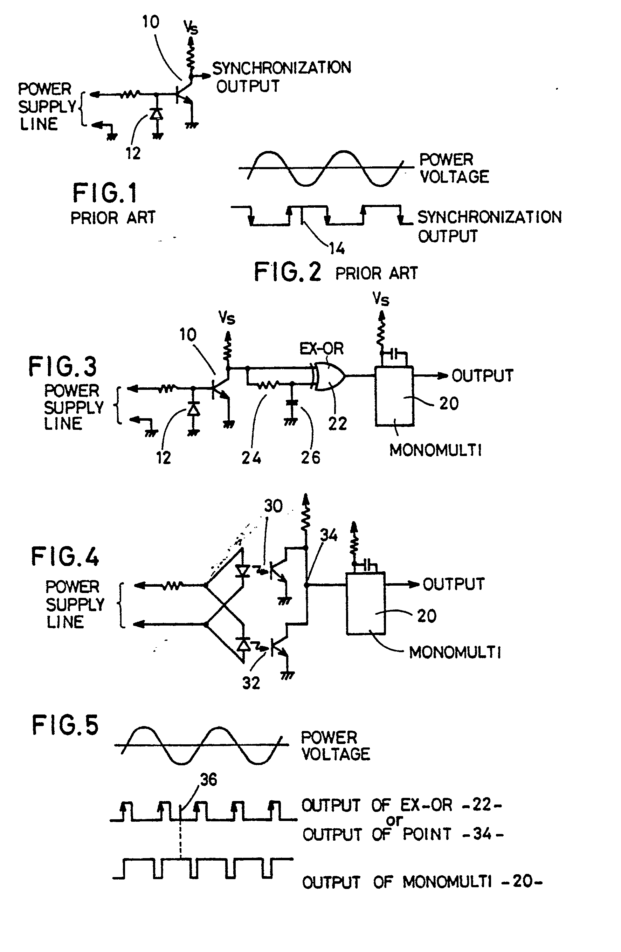

A signal transmission system has been developed which utilizes the building or house wiring as a data transmission line. In such a system, the power frequency is used as a base clock. To detect the power frequency, a zero-crossing level detection circuit is generally employed. FIGURE 1 shows a typical construction of the zero-crossing level detection circuit which includes a transistor 10 and a diode 12. A system timing signal is obtained through the use of the leading edge or the trailing edge of a synchronization output derived from the zero-crossing level detection circuit (see FIGURE 2).

In such a detection system, when noise is superimposed on the power supply voltage, there is a possibility that an erroneous detection output 14 appears in the synchronization output. Appearance of the erroneous detection output 14 depends on the noise level and the timing of the noise. The erroneous detection output 14 may lead to incorrect operation of the signal transmission system.

The frequency of occurrence of the erroneous detection output 14 is considerably lower than that of the power frequency. Furthermore, the power frequency is normally known. Therefore, if a system is constructed to ignore the power voltage variation for a preselected period of time after the last edge has been detected, the erroneous detection output 14 will be removed.

FIGURE 3 shows a first embodiment of the present invention. FIGURE 4 shows a second embodiment of the present invention. The two embodiments differ from each other at an edge detection section for detecting the zero-crossing moment of the power supply voltage. Both embodiments include a monomultivibrator 20 (not retriggerable).

The monomultivibrator 20 must be triggered by edges of a same polarity every half cycle of the power supply voltage. In the embodiment of FIGURE 3, a detection output of a zero-crossing level detection circuit, which includes the transistor 10 and the diode 12, is applied directly to one input terminal of an exclusive OR gate 22. The other input terminal of the exclusive OR gate 22 receives a delayed detection output from the zero-crossing detection circuit via an integration circuit including a resistor 24 and a capacitor 26. The output signal of the exclusive OR gate 22 is applied to the monomultivibrator 20.

In the embodiment of FIGURE 4, a zero-crossing level detection circuit includes photo-couplers 30 and 32 which function, in combination, as a wired OR gate.

A point 34 provides a detection output signal as shown in FIGURE 5. The detection output signal thus obtained is applied to the monomultivibrator 20.

It will be clear from FIGURE 5 that the output signal of the exclusive OR gate 22 in FIGURE 3 and the output signal obtained at the point 34 in FIGURE 4 both bear a high level when the power voltage polarity changes. That is, the output signals of the exclusive OR gate 22 and the photo-couplers 30 and 32 are zero-crossing detection signals. Once the monomultivibrator 20 is set, noise such as an erroneous detection signal 36 are neglected as long as the monomultivibrator 20 is in the set state. That is, the output signal of the monomultivibrator 20 is not influenced by the erroneous detection signal 36. To ensure an accurate operation of the power frequency detection systems of FIGURES 3 and 4, the pulse width of the monomultivibrator 20 is selected to be slightly shorter than one half of the period of the power supply votage. In a preferred form, the pulse width of the monomultivibrator 20 is selected at 7.5 milliseconds when the power supply voltage has a frequency of 60 Hz.

Attention is drawn to application EP-A-0186740, published 9.07.86, which has been divided out of the present application.

## Claims

1. A power line signal transmission system incorporating a detection system for detecting the frequency of a power voltage of said power line, the detection system being operable to provide detection signals when the instantaneous level of the power voltage reaches a predetermined value, and being arranged such that the provision of said detection signals is inhibited for a predetermined period after the provision of each detection signal by a nonretriggerable monostable multivibrator (20) the said predetermined period being less than the period of said power voltage and the multivibrator (20) being arranged to be triggered to generate a said detection signal in response to the power voltage reaching said predetermined value, each said detection signal comprising a pulse having a width substantially equal to the said predetermined period.

2. A system according to claim 1 in which the said predetermined value is substantially the centre value of the oscillations of the power voltage.

3. A system according to claim 1 or claim 2 in which the said pulse width is less than half the period of the power voltage and the system is operable to provide detection signals when the power voltage passes the predetermined value in either direction.

4. A system according to claim 3 which comprises detection circuit means (10, 12, 22, 24, 26; 30, 32, 34) which provides a trigger input pulse to the monostable multivibrator (20) when the power voltage passes the predetermined value, the detection circuit means providing a said trigger input pulse of the same polarity for movement of the power voltage past the predetermined value in either direction.

5. A system according to claim 4 in which the detection circuit means comprises level detection means (10,12) which outputs a signal to first and second inputs of an Exclusive-OR gate (22) which signal varies between a logic "1" and a logic "0" as the power voltage passes the predetermined value, the detection circuit means also comprising means (24, 26) to delay the signal at the second input of the Exclusive-OR gate (22) relative to the first so that following a movement of the power voltage past the predetermined value the logic value at the said first and second inputs do not change simultaneously, the output of the Exclusive-OR gate (22) being used to provide the said trigger input pulse.

6. A system according to claim 4 in which the detection circuit means comprises two photocouplers (30, 32) arranged so that one provides an output when the power voltage is substantially above the predetermined value and the other provides an output when the power voltage is substantially below the predetermined value, the outputs of the photocouplers (30, 32) being combined in an OR function so as to provide a combined output (34) of a first value when the power voltage is substantially different from the predetermined value and a second value when the power voltage is substantially at the predetermined value, the combined output (34) being used to provide the said trigger input pulse.

7. A system according to claim 6 in which each said photocoupler (30,32) comprises a light-emitting diode at its input side and a photo-transistor at its output side.

**Patentansprüche**

1. System zur Signalübertragung über eine Stromversorgungsnetzleitung mit einer Detektionseinrichtung zur Erfassung der Frequenz der Spannung auf der Netzleitung, welche Detektionssignale erzeugt, wenn der Momentanpegel der Netzspannung einen bestimmten Wert erreicht und die so ausgelegt ist, daß nach Erzeugung jedes Detektionssignals dieses durch einen nicht erneut triggerbaren monostabilen Multivibrator (20) für eine bestimmte Periode abgeschaltet wird, die kleiner ist als die Periode der Netzspannung, und der Multivibrator (20) zur Erzeugung des Detektionssignals in Abhängigkeit von dem Erreichen des bestimmten Wertes der Netzspannung triggerbar ist, sowie jedes Detektionssignal einen Puls aufweist, dessen Länge im wesentlichen gleich der bestimmten Periode ist.

2. System nach Anspruch 1, dadurch gekennzeichnet, daß der bestimmte Wert im wesentlichen der mittlere Wert der Schwingungen der Netzspannung ist.

3. System nach einem der Ansprüche 1 oder 2, dadurch gekennzeichnet, daß die Pulslänge kürzer ist als die halbe Periode der Netzspannung und das System Detektionssignale erzeugt, wenn die Netzspannung den bestimmten Wert in einer der beiden Richtungen überschreitet.

4. System nach Anspruch 3, gekennzeichnet durch eine Detektionsschaltung (10, 12, 22, 24, 26; 30, 32, 34), die dem monostabilen Multivibrator (20) einen Eingangs-Triggerpuls zuführt, wenn die Netzspannung den bestimmten Wert überschreitet, und die einen Eingangs-Triggerpuls derselben Polarität bei Veränderung der Netzspannung jenseits des bestimmten Wertes in beiden Richtungen erzeugt.

5. System nach Anspruch 4, dadurch gekennzeichnet, daß die Detektionsschaltung Pegeldetektoren (10, 12) aufweist, die Ausgangssignale an erste und zweite Eingänge eines Exklusiv-ODER-Glieds (22) leiten, welche zwischen den logischen Werten "1" und "0" umschalten, wenn die Netzspannung den bestimmten Wert überschreitet, daß die Detektionsschaltung Mittel (24, 26) aufweist, die das Signal an zweiten Eingang des Exklusiv-ODER-Glieds (22) gegenüber dem Signal am ersten Eingang so verzögern, daß nach einer veränderung der Netzspannung jenseits des bestimmten Wertes sich die logischen Werte an den ersten und zweiten Eingängen nicht gleichzeitig ändern, und daß das Ausgangssignal des Exklusiv-ODER-Glieds (22) als Eingangs-Triggerpuls dient.

6. System nach Anspruch 4, dadurch gekennzeichnet, daß die Detektionsschaltung zwei Photokoppler (30, 32) aufweist, die so angeordnet sind, daß einer ein Ausgangssignal erzeugt, wenn die Netzspannung über dem bestimmten Wert liegt und der andere ein Ausgangssignal erzeugt, wenn die Netzspannung unterhalb des bestimmten Wertes liegt, daß die Ausgänge der Photokoppler (30, 32) zur Erzeugung eines gemeinsamen Ausgangs (34) ODER-verknüpft sind, der einen ersten Wert einnimmt, wenn die Netzspannung verschieden ist von dem bestimmten Wert und einen zweiten Wert einnimmt, wenn die Netzspannung gleich dem bestimmten Wert ist, und daß der gemeinsame Ausgang (34) zur Erzeugung des Eingangs-Triggerpulses dient.

7. System nach Anspruch 6, dadurch gekennzeichnet, daß jeder Photokoppler (30, 32) an seinem Eingang eine lichtemittierende Diode und an seinem Ausgang einen Phototransistor aufweist.

**Revendications**

1. Système de transmission de signaux par une ligne de transport d'énergie, incluant un dispositif de détection destiné à détecter la fréquence d'une tension électrique de ladite ligne de transport d'énergie, ce dispositif de détection pouvant intervenir pour fournir des signaux de détection lorsque le niveau instantané de la tension électrique atteint une valeur prédéterminée, et étant conçu de telle façon que la fourniture desdits signaux de détection est interrompue sur une période prédéterminée après que chaque signal de détection a été délivré par un multivibrateur monostable non-redéclenchable (20), ladite période prédéterminée étant inférieure à la période de ladite tension électrique et le multivibrateur (20) étant conçu pour être déclenché afin d'engendrer un dit signal de détection en réponse au fait que la tension électrique a atteint ladite valeur prédéterminée, chacun desdits signaux de détection contenant une impulsion dont la largeur est sensiblement égale à ladite période prédéterminée.

2. Système selon la revendication 1, dans lequel ladite valeur prédéterminéé est sensiblement la valeur médiane des oscillations de la tension électrique.

3. Système selon la revendication 1 ou la revendication 2, dans lequel la largeur de ladite impulsion est inférieure à la moitié de la période de la tension électrique et le dispositif peut intervenir pour délivrer des signaux de détection lorsque la tension électrique passe d'un côté ou de l'autre de la valeur prédéterminée.

4. Système selon la revendication 3, qui comprend des moyens (10, 12, 22, 24, 26; 30, 32, 34) formant un circuit de détection qui délivre une impulsion pour l'entrée de déclenchement du multivibrateur monostable (20) lorsque la tension électrique passe par la valeur prédéterminée, les moyens formant le circuit de détection fournissant une impulsion pour ladite entrée de déclenchement, qui a une polarité correspondant au sens dans lequel la tension électrique varie pour passer d'un côté ou de l'autre de la valeur prédéterminée.

5. Système selon la revendication 4, dans lequel les moyens formant le circuit de détection comprennent un moyen de détection de niveau (10, 12), qui délivre un signal aux première et seconde entrées d'une porte OU-exclusif (22), signal qui varie entre un "1" logique et un "0" logique quand la tension électrique passe par la valeur prédéterminée, les moyens formant circuit de détection comprenant encore un moyen (24, 26) pour retarder le signal sur la seconde entrée de la porte OU-exclusif (22) par rapport à la première, pour qu'à la suite d'une variation de la tension électrique la faisant passer par la valeur prédéterminée, les valeurs logiques desdits premier et second signaux d'entrée ne changent Pas simultanément, la sortie de la porte OU-exclusif (22) étant utilisée pour fournir l'impulsion pour ladite entrée de déclenchement.

6. Système selon la revendication 4, dans lequel les moyens formant circuit de détection comprennent deux opto-coupleurs (30, 32) agencés de telle façon que l'un délivre un signal de sortie quand la tension électrique est sensiblement au-dessus de la valeur prédéterminée et l'autre produit un signal de sortie quand la tension électrique est sensiblement au-dessous de la valeur prédéterminée, les signaux de sortie des opto-coupleurs (30, 32) étant rassemblés en une fonction logique OU pour fournir un signal de sortie combiné (34) prenant une première valeur lorsque la tension électrique est sensiblement différente de la valeur prédéterminée et une seconde valeur lorsque cette tension électrique est sensiblement égale à la valeur prédéterminée, le signal de sortie combiné (34) étant utilisé comme impulsion pour ladite entrée de déclenchement.

7. Système selon la revendication 6, dans lequel chacun desdits opto-coupleurs (30, 32) comprend une diode électroluminescente du côté de son entrée et un photo-transistor du côté de la sortie.

0 112 948

FIG.1
PRIOR ART

FIG.2 PRIOR ART

FIG.3

FIG.4

FIG.5

1